# EUROPEAN PATENT SPECIFICATION

(11) **EP 3 863 014 B1**
(45) Date of publication and mention of the grant of the patent: **29.10.2025**
(21) Application number: 21155509.9
(22) Date of filing: 05.02.2021
(51) Int. Cl.: G11C 7/10, G11C 8/16, G11C 11/412

(54) **COMPUTATIONAL MEMORY CELL AND PROCESSING ARRAY DEVICE WITH RATIOLESS WRITE PORT**
RECHNERGESTEUERTE SPEICHERZELLE UND VERARBEITUNGSANORDNUNGSVORRICHTUNG MIT VERHÄLTNISLOSEM SCHREIBPORT
CELLULE DE MÉMOIRE DE CALCUL ET DISPOSITIF DE RÉSEAU DE TRAITEMENT AVEC PORT D'ÉCRITURE SANS RAPPORT

(30) Priority: 07.02.2020 US 202016785141
(43) Date of publication of application: 11.08.2021
(73) Proprietor: GSI Technology Inc., Sunnyvale, CA 94089 (US)
(72) Inventor: CHUANG, Patrick, Sunnyvale, CA 94089 (US); CHANG, Chao-Hung, Sunnyvale, CA 94089 (US); SHU, Lee-Lean, Sunnyvale, CA 94089 (US)
(74) Representative: Betten & Resch

(56) References cited:
- US-A1- 2012 212 996
- US-A1- 2016 254 045
- US-A1- 2018 158 519

## Description

### FIELD

The disclosure relates generally to a static random access memory cell that may be used for computations.

### BACKGROUND

An array of memory cells, such as dynamic random access memory (DRAM) cells, static random access memory (SRAM) cells, content addressable memory (CAM) cells or non-volatile memory cells, is a well-known mechanism used in various computer or processor based devices to store digital bits of data. The various computer and processor based devices may include computer systems, smartphone devices, consumer electronic products, televisions, internet switches and routers and the like. The array of memory cells are typically packaged in an integrated circuit or may be packaged within an integrated circuit that also has a processing device within the integrated circuit. The different types of typical memory cells have different capabilities and characteristics that distinguish each type of memory cell. For example, DRAM cells take longer to access, lose their data contents unless periodically refreshed, but are relatively cheap to manufacture due to the simple structure of each DRAM cell. SRAM cells, on the other hand, have faster access times, do not lose their data content unless power is removed from the SRAM cell and are relatively more expensive since each SRAM cell is more complicated than a DRAM cell. CAM cells have a unique function of being able to address content easily within the cells and are more expensive to manufacture since each CAM cell requires more circuitry to achieve the content addressing functionality.

Various computation devices that may be used to perform computations on digital, binary data are also well-known. The computation devices may include a microprocessor, a CPU, a microcontroller and the like. These computation devices are typically manufactured on an integrated circuit, but may also be manufactured on an integrated circuit that also has some amount of memory integrated onto the integrated circuit. In these known integrated circuits with a computation device and memory, the computation device performs the computation of the digital binary data bits while the memory is used to store various digital binary data including, for example, the instructions being executed by the computation device and the data being operated on by the computation device.

More recently, devices have been introduced that use memory arrays or storage cells to perform computation operations. In some of these devices, a processor array to perform computations may be formed from memory cells. These devices may be known as in-memory computational devices.

Big data operations are data processing operations in which a large amount of data must be processed. Machine learning uses artificial intelligence algorithms to analyze data and typically require a lot of data to perform. The big data operations and machine learning also are typically very computationally intensive applications that often encounter input/output issues due to a bandwidth bottleneck between the computational device and the memory that stores the data. The above in-memory computational devices may be used, for example, for these big data operations and machine learning applications since the in-memory computational devices perform the computations within the memory thereby eliminating the bandwidth bottleneck.

An SRAM cell can be configured to perform Boolean operations such as AND, OR, NAND and NOR, Exclusive OR and NOR. This SRAM cell can also support a Selective Write operation. However, the typical SRAM cell requires stronger writing transistors than the transistors in the storage latch to over write the storage data. A ratio of the transistor strengths of the write transistor and the storage transistor may be known as a write ratio. For a typical SRAM cell, the write ratio is 2 to 3 meaning that the writing transistor is 2 to 3 times of the strength of the storage transistor for the writing to be successful. Thus, it is desired to provide a computational memory cell, that may be an SRAM cell, with a write port to perform Boolean operations such as AND, OR, NAND, NOR, XOR (Exclusive OR) and XNOR (Exclusive NOR) that is able to do the writing ratioless.

US 20180158519 A1 discloses a memory cell and processing array that has a plurality of memory capable of performing logic functions, including an exclusive OR (XOR) or an exclusive NOR (XNOR) logic function.

US 2012/212996 A1 discloses a memory device including a memory array comprising a plurality of memory cells. At least a given one of the memory cells comprises a pair of cross-coupled inverters and associated write assist circuitry. The write assist circuitry comprises first switching circuitry coupled between a supply node of a device of the first inverter and a supply node of the memory cell, and second switching circuitry coupled between a supply node of a device of the second inverter and the supply node of the memory cell.

### BRIEF DESCRIPTION OF THE DRAWINGS

Figure 1 illustrates a dual port SRAM cell that can perform Boolean operations;
Figure 2 illustrates an implementation of a processing array that has a plurality of the SRAM cells shown in Figure 1 and performs logic functions;
Figure 3 illustrates a write port truth table for the dual port SRAM cell of Figure 1 with a selective write function;
Figure 4 illustrates an implementation of a dual port SRAM cell that can perform Boolean operations and ratioless selective write.
Figure 5 illustrates an implementation of a 3-port SRAM cell that can perform basic Boolean operations, XOR and XNOR functions and ratioless selective write; and
Figure 6 illustrates an implementation of a processing array that has a plurality of the SRAM cells shown in Figure 5 and performs basic Boolean operations, XOR and XNOR functions.

### DETAILED DESCRIPTION OF ONE OR MORE EMBODIMENTS

The present invention is defined in the independent claims. The dependent claims define embodiments of the invention.

According to implementations, a computational memory cell and processing array have a ratioless write port so that a write to the memory cell does not need to overcome the drive strength of a PMOS transistor that is part of the storage cell of the memory cell. The computational memory cell also may have a second read port that has an isolation circuit.

The disclosure is particularly applicable to a CMOS implemented memory cell and processing array with a plurality of the memory cells that are capable to performing logic functions with a ratioless write port and it is in this context that the disclosure will be described. It will be appreciated, however, that the memory cell and processing array has greater utility and is not limited to the below disclosed implementations since the memory cell may be constructed using different processes and may have different circuit configurations than those disclosed below that perform the logic function and so are within the scope of this disclosure. For purposes of illustration, a dual port SRAM and 3-port cells are disclosed below and in the figures. However, it is understood that the SRAM computation cell and processing array may also be implemented with an SRAM cell having more ports and the disclosure is not limited to the SRAM cells disclosed below. It is also understood that the SRAM cells having more ports may be slightly differently constructed than the SRAM cells shown in the figures, but one skilled in the art would understand how to construct those SRAMs with more ports from the disclosure below.

Furthermore, although an SRAM cell is used in the examples below, it is understood that the disclosed memory cell for computation and the processing array using the memory cells may be implemented using various different types of memory cells including DRAMs, CAMs, non-volatile memory cells and non-volatile memory devices and these implementations using the various types of memory cells are within the scope of the disclosure.

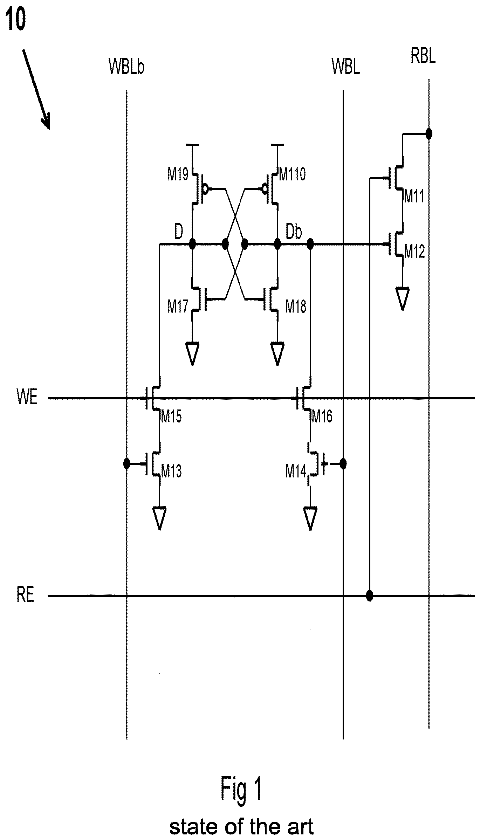

Figure 1 illustrates a dual port SRAM cell 10 not forming part of the invention that may be used for computation. The dual port SRAM cell may include two cross coupled inverters (transistors M17, M19 pair as one inverter and transistors M18 and M110 pair as another inverter) that form a latch or storage cell and access transistors M11-M16 that are coupled together as shown in Figure 1 to form an SRAM cell. The SRAM cell may be operated as a storage latch and may have a read port and a write port so that the SRAM cell is a dual port SRAM cell. The two inverters are cross coupled since the input of the first inverter is connected to the output of the second inverter and the output of the first inverter is coupled to the input of the second inverter as shown in Figure 1.

A Write Word line carries a signal and is called WE (see Figure 1) and a write bit line and its complement are called WBL and WBLb, respectively. The Write word line (WE) is coupled to the gate of each of the two access transistors M15, M16 that are part of the SRAM cell. The write bit line and its complement (WBL and WBLb) are each coupled to a gate of the respective access transistors M13, M14 as shown in Figure 1 and M13 is coupled to M15 and M14 is coupled to M16. The source of each of transistors M13 and M14 is coupled to ground. The drain of each of those access transistors M15, M16 is coupled to each side of the cross coupled inverters (labeled D and Db in Figure 1).

The circuit in Figure 1 may also have a read word line RE, a read bit line RBL and a read port formed by transistors M11, M12 coupled together to form an isolation circuit. The read word line RE may be coupled to the gate of transistor M11 that forms part of the read port while the read bit line is coupled to the drain terminal of transistor M11. The gate of transistor M12 may be coupled to the Db output from the cross coupled inverters and the source of transistor M12 may be coupled to ground.

In operation, the dual port SRAM cell may read data stored in the latch using a signal on the read word line (RE) to address/activate the dual port SRAM cell and the read bit line (RBL) to read the data stored in the dual port SRAM cell. The dual port SRAM cell may write data into the dual port SRAM cell by addressing/activating the dual port SRAM cell using a signal on the write word line (WE) and then writing data into the dual port SRAM cell using the write bit lines (WBL, WBLb).

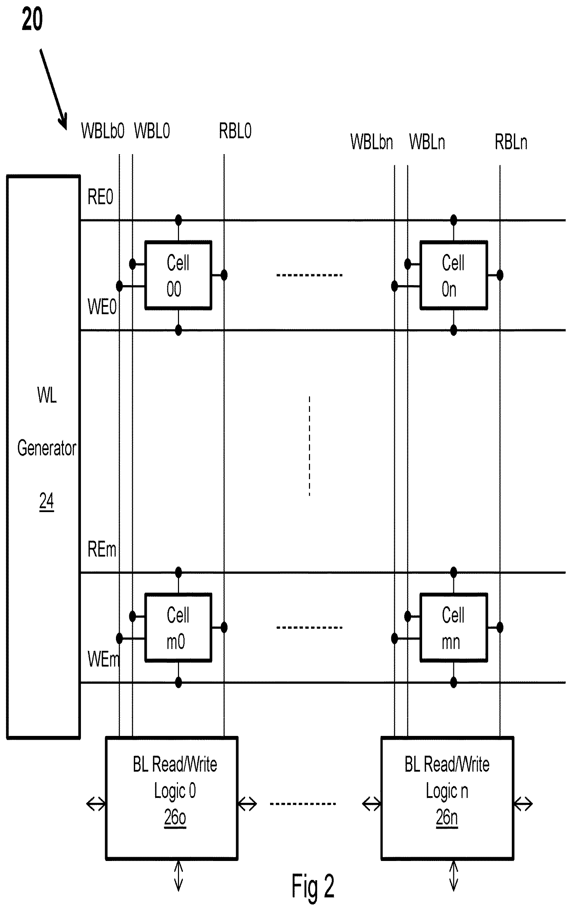

During reading, multiple cells (with only a single cell being shown in Figure 1 but multiple cells shown in Figure 2) can be turned on to perform an AND function between the data stored in the cells that were turned on. For example, a number of cells in a column of the processing array 20 in Figure 2, such as cell 00,..., cell m0, may be activated by the RE signal for each of those cells. Thus, at the beginning of the read cycle, RBL is pre-charged high and if the Db signal of all cells that are turned on by RE are "0", then RBL stays high. Although the gate of transistor M11 is turned on by the RE signal, the gate of M12 is not turned on since the Db signal is low. As a result, the RBL line is not connected to the ground to which the source of transistor M12 is connected and the RBL line is not discharged. The write operation is activated by WE and the data is written by toggling of WBL and WBLb. The read operation is activated by RE and the read data is accessed on RBL.

The cell 10 may further be used for computation where RBL is also used to perform logic operation(s). If the Db signal of any or all of the cells activated is "1" then RBL is discharged to 0 since the gate of M12 is turned on and the RBL line is connected to ground. As a result, RBL = NOR (Db0, Db1, etc.) where Db0, Db1, etc. are the complementary data of the SRAM cells that have been turned on by the RE signal. Alternatively, RBL = NOR (Db0, Db1, etc.) = AND (D0, D1, etc.), where D0, D1, etc. are the true data of the cells that have been turned on by the RE signal.

As shown in Figure 1, the Db signal of the cell 10 may be coupled to a gate of transistor M12 to drive the RBL line. The Db signal is isolated from the RBL line and its signal/voltage level by the transistors M11, M12 (together forming the isolation circuit). Because the Db signal/value is isolated from the RBL line and signal/voltage level, the Db signal is not susceptible to the lower bit line level caused by multiple "0" data stored in multiple cells. Therefore, for the cell in Figure 1, there is no limitation of how many cells can be turned on to drive RBL. As a result, the cell (and the device made up of multiple cells) offers more operands for the Boolean functions such as AND function described above and NOR/OR/NAND/XOR/XNOR functions described in co-pending and commonly owned 15/709,401 filed September 19, 2017 (now issued as US Patent 10,249,362 on April 2, 2019) and 15/709,399 filed September 19, 2017 and U.S. Provisional Application No. 62/430,767 filed December 6, 2016 since there is no limit of how many cells can be turned on to drive RBL. In addition to the AND function described above, the SRAM cell 10 in Figure 1 also may perform a NOR function by storing inverted data. Specifically, if D is stored at the gate of M12, instead of Db, then RBL = NOR (D0, D1, etc.).

Figure 2 illustrates a processing array device 20 that may incorporate the dual port SRAM cell of Figure 1, in which each cell, such as cell 00, ..., cell On and cell m0, ...., cell mn, is the cell shown in Figure 1. The cells form an array of cells laid out as shown in Figure 2. The processing array 20 may perform computations using the computational capabilities of the dual port SRAM cell described above. The array device 20 may be formed by M word lines (such as RE0, WE0,...., REm, WEm) and N bit lines (such as WBL0, WBLb0, RBL0, ...., WBLn, WBLbn, RBLn.) The array device 20 may also include a word line generator 24 (WL Generator) that generates word line signals as well as a plurality of bit line read/write logic 26 (such as BL Read/Write Logic 0,...., BL Read/Write Logic n) that perform read and write operations using the bit lines. The array device 20 may be manufactured on an integrated circuit or may be integrated into another integrated circuit depending on the use of the processing array 20.

In a read cycle, the word line generator 24 may generate one or multiple RE signals in a cycle to turn on/activate one or more cells and the RBL lines of the cells activated by the RE signal form AND or NOR functions whose output is sent to a respective BL Read/Write Logic (26o,..., 26n). Each BL Read/Write Logic 26 processes the RBL result (the result of the AND or NOR operation) and sends the results back to its WBL/WBLb for use/writing back to the same BL, or to the neighboring BL Read/Write Logic 26 for use/writing back to the neighboring BL, or send it out of the processing array. Alternatively, the BL Read/Write logic 26 can store the RBL result from its own bit line or from the neighboring bit line in a latch within the BL Read/Write Logic so that, during a next or later cycle, the BL Read/Write logic 26 can perform logic with the latched data that is the RBL result.

In a write cycle, the word line generator 24 generates one or more WE signals for the cells into which data is to be written. The BL Read/Write Logic (26o,..., 26n) processes the write data, either from its own RBL, or from the neighboring RBL, or from out of the processing array 20. The ability of BL Read/Write Logic 26 to process the data from the neighboring bit line means that the data can be shifting from one bit line to the neighboring bit line and one or more or all bit lines in the processing array may be shifting concurrently. The BL Read/Write Logic 26 can also decide not to write for a Selective Write operation based on the RBL result. For example, the data on the WBL line can be written to a cell if RBL=1. If RBL=0, then the write operation is not performed.

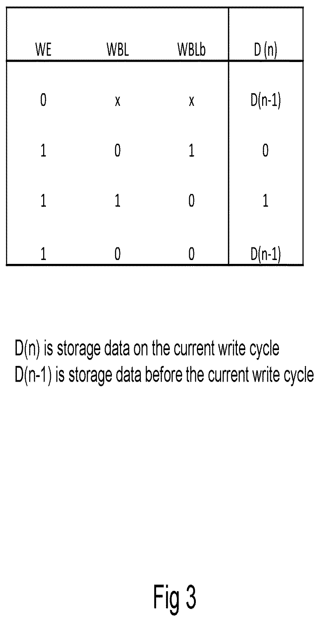

Figure 3 illustrates a write port truth table for the dual port SRAM cell of Figure 1. If WE is 0, no write is performed (as reflected by the D(n-1) shown in Figure 3). If WE is 1, then the storage nodes D and its complement Db are written by WBL and WBLb. D=1 and Db=0 if WBL=1 and WBLb=0. D=0 and Db=1 if WBL=0 and WBLb=1. If both WBL and WBLb are 0, then no write is performed. So this cell can perform Selective Write function with WBL=WBLb=0, with WE=1.

The write operation for the circuit is now described in more detail with reference to Fig 1. When WE=1 and either WBL and WBLb is 1, the writing is performed. To write D from 1 to 0, then WBLb=1 and WBL=0, M13 and M15 are turned on to overcome the strength of PMOS transistor M19. On 16nm or more advanced process technology with FINFET transistors, PMOS transistor normally has almost same driver strength as an NMOS transistor, and driver strength of M13 and M15 in series need to be 3 times or more than the driver strength of M19 to be able to perform the writing successfully. Therefore M13 and M15 each needs to be 6 times of driver strength of M19. Similarly M14 and M16 each needs to be 6 times of M110. This makes M13, M14, M15 and M16 transistors sizes very large that in turn results in the cell 10 size of Fig 1 being large.

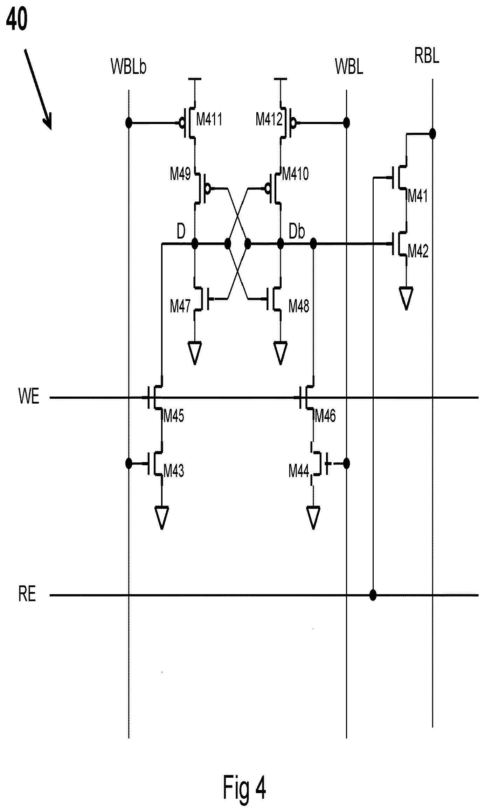

The circuit 40 in Fig 4 improves the write port transistor size issue by modifying the circuit shown in Figure 1 to be ratioless during a write operation. The table in Fig 3 applies to circuit 40 in Fig 4 since the circuit 40 in Figure 4 has the same elements and operates in the same manner as the circuit 10 in Figure 1, but has a ratioless write operation as described below. The cell 40 may also replace the cell 10 and be used seamlessly in the processing array 20 in Figure 2.

In the cell 40 in Figure 4, if WE=0, no write is performed by the circuit in Figure 4. If WE is 1, then the storage nodes D and its complement Db are written by WBL and WBLb in which D=1 and Db=0 if WBL=1 and WBLb=0 and D=0 and D=1 if WBL=0 and WBLb=1. If both WBL and WBLb are 0, then no write is performed so this cell 40 can perform a selective write function with WBL=WBLb=0 and with WE=1 as did the circuit 10 in Figure 1.

In Fig 4, when WE=1, WBLb=1 and WBL= 0, transistors M43 and M45 are on and data D is written from 1 to 0 without the pull up strength of series PMOS transistors of M49 and M411 because transistor M411 is turned off when its gate is tied to WBLb which is 1. Furthermore, because WBL=0, transistor M412 is turned on and data D is pulled down to 0, therefore Db is pulled up from 0 to 1 and the writing is completed. In this write operation using the circuit 40 in Figure 4, there is no write ratio in the write operation as M43 and M45 pull down D without the need to overcome the PMOS pull up strength of the storage transistor.

Similarly, when WE=1, WBLb=0 and WBL= 1, transistors M44 and M46 are on and data Db is written from 1 to 0 without needing to overcome the pull up strength of series PMOS transistor M410 and M412 because transistor M412 is turned off with the gate tied to WBL. Similarly, in this write operation, there is no write ratio in the write operation as M44 and M46 operate without the need to overcome the storage PMOS pull up strength.

In this manner, write port transistor M43, M44, M45 and M46 may be the same minimum size of transistor as PMOS transistors M49, M410, M411 and M412. Thus, the cell 40 size can be reduced and the write port is not affected by the write ratio. Note that when WE=0, no write is performed, but M411 or M412 may be turned ON when WBLb or WBL is 1. This could leave D or Db as floating 1 which is acceptable because the write cycle is only for a short period of time and nodes D and Db have enough capacitance to hold the change to keep the value in the storage cell unchanged in this situation. In the normal operation when it is not a write cycle, both WBLb and WBL are low to keep the cross coupled transistors M47, M48, M49 and M410 operating as the cross coupled latch of the SRAM cell 40.

In the circuit 40 shown in Fig 4, series transistor pair M49, M411 and M410, M412 can swap position to achieve the same function. For example, M49 may have its gate tied to Db and is coupled to VDD and the source of M411 while M411 has its gate tied to WBLb that is coupled to D. Similarly series transistor pair M43, M45 and M44, M46 can swap position to achieve the same function.

In summary, a ratioless write is performed with write bit line (WBL) or complementary write bit line (WBLb) to write the "0" node of the storage latch with its pull up transistor disabled and to write the "1" node of the storage latch with its pull up transistor enabled. The cell 40 in Fig 4 can be used in the processing array 20 in Fig 2 in the same way as cell 10 in Fig 1.

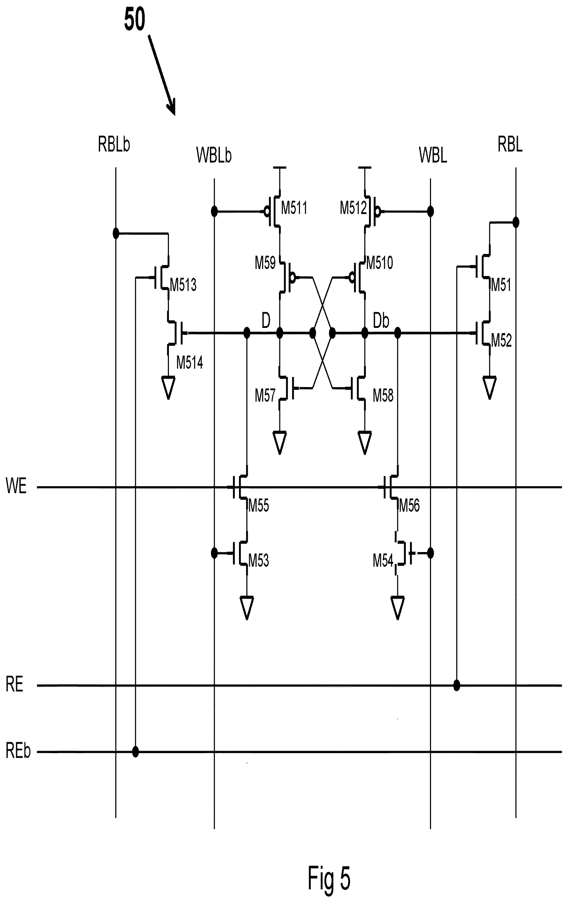

Figure 5 illustrates an implementation of a 3-port SRAM cell 50 that can perform basic Boolean operations, XOR and XNOR functions and ratioless selective write. The cell 50 has the same storage latch and write port circuitry as cell 40, therefore, the same ratioless selective write operation as cell 40. The cell 50 in Fig 5 adds another read port to the cell 40 in Fig 4. Transistors M513 and M514 are added to form the second read port and an isolation circuit for that second read port. In this circuit 50, the complementary read word line REb may be coupled to the gate of transistor M513 that forms part of the read port while the complementary read bit line RBLb is coupled to the drain terminal of transistor M513. The gate of transistor M514 may be coupled to the D output from the cross coupled inverters and the source of transistor M514 may be coupled to ground.

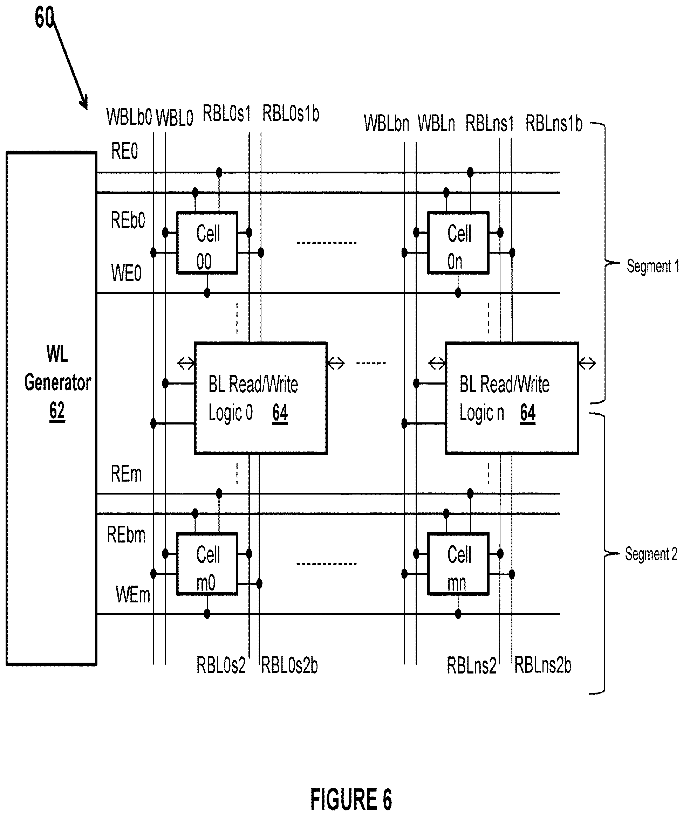

During reading, multiple cells (with only a single cell being shown in Figure 5 but multiple cells shown in a processing array 60 in Figure 6) can be turned on to perform an AND function between the complementary data stored in the cells that were turned on. During the read, the RBLb line is precharged high. If the D signal of any or all of the cells activated is "1" then RBLb is discharged to 0 since the gate of M514 is turned on and the RBLb line is connected to ground. As a result, RBLb = NOR (D0, D1, etc.) where D0, D1, etc. are the data of the SRAM cells that have been turned on by the REb signal. Alternatively, RBLb = NOR (D0, D1, etc.) = AND (Db0, Db1, etc.), where Db0, Db1, etc. are the complement data of the cells that have been turned on by the REb signal. Thus, cell 50 performs as 3-port SRAM cell with a write port (controlled by WE) and 2 read ports (controlled by RE and Reb) with RBL=AND (D0, D1, etc) and RBLb=(D0b, D1b, etc).

Figure 6 illustrates an implementation of a processing array 60 that has a plurality of the 3-port SRAM cells shown in Figure 5 in an array and split segments (Segment 1 and Segment 2 as shown) and each of the bit line (BL) read/write logic circuitry 64 (BL Read/Write Logic 0,..., BL Read/Write Logic n for each bit line) in the middle of each bit line. This processing array has a word line generator 62 that generates control signals (RE0, ..., REm, REb0, ..., REbm and WEO, ..., WEm) and each bit line has the two segments. In one embodiment, segment 1 has RBLs1 and RBLs1b read bit lines (RBL0s1, ..., RBLns1 and RBL0s1b, ..., RBLns1b) with number of cells connected on it (cell 00, ...., cell 0n in the example in Figure 6) which are all connected to the BL read/write circuitry 64 and segment 2 has RBLs2 and RBLs2b lines (RBL0s2, ..., RBLns2 and RBL0s2b, ..., RBLns2b) with a number of cells (cell m0, ..., cell mn in the example in Figure 6) which are all connected to another input of the BL read/write circuitry 64.

In a read cycle, the word line generator may generate one or multiple RE, REb signals in a cycle to turn on/activate one or more cells and the RBL, RBLb lines of the cells activated by the RE and REb signals form AND or NOR functions whose output is sent to the respective BL Read/Write Logic 64 for each bit line. Each BL Read/Write Logic 64 processes the RBL result (the result of the AND or NOR operation) and sends the results back to its WBL/WBLb for use/writing back to the same cell, or to the neighboring BL Read/Write Logic for use/writing back to the neighboring cell, or send it out of the processing array. Alternatively, the BL Read/Write logic 64 can store the RBL result from its own bit line or from the neighboring bit line in a latch within the BL Read/Write Logic so that, during a next or later cycle, the Read/Write logic can perform logic with the latched data that is the RBL result.

In a write cycle using the processing array in Figure 6, the word line generator 62 generates one or more WE signals for the one or more cells into which data is to be written. The BL Read/Write Logic 64 processes the write data, either from its own RBL, or from the neighboring RBL, or from out of the processing array. The ability of BL Read/Write Logic 64 to process the data from the neighboring bit line (note the connections between the bit lines and each BL Read/Write Logic 64) means that the data can be shifting from one bit line to the neighboring bit line and one or more or all bit lines in the processing array may be shifting concurrently. The BL Read/Write Logic 64 can also decide not to write for a Selective Write operation based on the RBL or RBLb result. For example, the data on the WBL line can be written to a cell if RBL=1. If RBL=0, then write operation is not performed.

### SRAM Ultralow VDD Operation SRAM

The cells 40 and 50 described here are for computation memory applications, but these cells in Figures 4 and 5 can be operated as an SRAM cell with great noise immunity and ultralow VDD operation. Specifically, the VDD operation level can be as low as the threshold voltage of NMOS and PMOS transistors of the cell.

**Isolated storage latch:** the read or write operation will not affect the stability of storage latch. The VDD operation level for storage is as low as the threshold voltage of NMOS and PMOS transistors for the cross coupled latch to be active.

**Buffered read:** the read bit line voltage level will not affect the stability of the storage node. The read bit line is pre-charged high and be discharged by the turning on of the read port access transistors. The VDD operation level is as low as the threshold voltage of read port NMOS transistors.

**Ratioless write:** The writing to the storage latch occurs by just turning on the NMOS or PMOS transistors of the write port without write ratio. The VDD operation level is as low as the threshold voltage of write port NMOS and PMOS transistors.

The foregoing description, for purpose of explanation, has been described with reference to specific embodiments. However, the illustrative discussions above are not intended to be exhaustive or to limit the disclosure to the precise forms disclosed. Many modifications and variations are possible in view of the above teachings. The embodiments were chosen and described in order to best explain the principles of the disclosure and its practical applications, to thereby enable others skilled in the art to best utilize the disclosure and various embodiments with various modifications as are suited to the particular use contemplated.

The system and method disclosed herein may be implemented via one or more components, systems, servers, appliances, other subcomponents, or distributed between such elements. When implemented as a system, such systems may include an/or involve, inter alia, components such as software modules, general-purpose CPU, RAM, etc. found in general-purpose computersP. In implementations where the innovations reside on a server, such a server may include or involve components such as CPU, RAM, etc., such as those found in general-purpose computers.

Additionally, the system and method herein may be achieved via implementations with disparate or entirely different software, hardware and/or firmware components, beyond that set forth above. With regard to such other components (e.g., software, processing components, etc.) and/or computer-readable media associated with or embodying the present inventions, for example, aspects of the innovations herein may be implemented consistent with numerous general purpose or special purpose computing systems or configurations. Various exemplary computing systems, environments, and/or configurations that may be suitable for use with the innovations herein may include, but are not limited to: software or other components within or embodied on personal computers, servers or server computing devices such as routing/connectivity components, hand-held or laptop devices, multiprocessor systems, microprocessor-based systems, set top boxes, consumer electronic devices, network PCs, other existing computer platforms, distributed computing environments that include one or more of the above systems or devices, etc.

In some instances, aspects of the system and method may be achieved via or performed by logic and/or logic instructions including program modules, executed in association with such components or circuitry, for example. In general, program modules may include routines, programs, objects, components, data structures, etc. that perform particular tasks or implement particular instructions herein. The inventions may also be practiced in the context of distributed software, computer, or circuit settings where circuitry is connected via communication buses, circuitry or links. In distributed settings, control/instructions may occur from both local and remote computer storage media including memory storage devices.

The software, circuitry and components herein may also include and/or utilize one or more type of computer readable media. Computer readable media can be any available media that is resident on, associable with, or can be accessed by such circuits and/or computing components. By way of example, and not limitation, computer readable media may comprise computer storage media and communication media. Computer storage media includes volatile and nonvolatile, removable and non-removable media implemented in any method or technology for storage of information such as computer readable instructions, data structures, program modules or other data. Computer storage media includes, but is not limited to, RAM, ROM, EEPROM, flash memory or other memory technology, CD-ROM, digital versatile disks (DVD) or other optical storage, magnetic tape, magnetic disk storage or other magnetic storage devices, or any other medium which can be used to store the desired information and can accessed by computing component. Communication media may comprise computer readable instructions, data structures, program modules and/or other components. Further, communication media may include wired media such as a wired network or direct-wired connection, however no media of any such type herein includes transitory media. Combinations of the any of the above are also included within the scope of computer readable media.

In the present description, the terms component, module, device, etc. may refer to any type of logical or functional software elements, circuits, blocks and/or processes that may be implemented in a variety of ways. For example, the functions of various circuits and/or blocks can be combined with one another into any other number of modules. Each module may even be implemented as a software program stored on a tangible memory (e.g., random access memory, read only memory, CD-ROM memory, hard disk drive, etc.) to be read by a central processing unit to implement the functions of the innovations herein. Or, the modules can comprise programming instructions transmitted to a general purpose computer or to processing/graphics hardware via a transmission carrier wave. Also, the modules can be implemented as hardware logic circuitry implementing the functions encompassed by the innovations herein. Finally, the modules can be implemented using special purpose instructions (SIMD instructions), field programmable logic arrays or any mix thereof which provides the desired level performance and cost.

As disclosed herein, features consistent with the disclosure may be implemented via computer-hardware, software and/or firmware. For example, the systems and methods disclosed herein may be embodied in various forms including, for example, a data processor, such as a computer that also includes a database, digital electronic circuitry, firmware, software, or in combinations of them. Further, while some of the disclosed implementations describe specific hardware components, systems and methods consistent with the innovations herein may be implemented with any combination of hardware, software and/or firmware. Moreover, the above-noted features and other aspects and principles of the innovations herein may be implemented in various environments. Such environments and related applications may be specially constructed for performing the various routines, processes and/or operations according to the invention or they may include a general-purpose computer or computing platform selectively activated or reconfigured by code to provide the necessary functionality. The processes disclosed herein are not inherently related to any particular computer, network, architecture, environment, or other apparatus, and may be implemented by a suitable combination of hardware, software, and/or firmware. For example, various general-purpose machines may be used with programs written in accordance with teachings of the invention, or it may be more convenient to construct a specialized apparatus or system to perform the required methods and techniques.

Aspects of the method and system described herein, such as the logic, may also be implemented as functionality programmed into any of a variety of circuitry, including programmable logic devices ("PLDs"), such as field programmable gate arrays ("FPGAs"), programmable array logic ("PAL") devices, electrically programmable logic and memory devices and standard cell-based devices, as well as application specific integrated circuits. Some other possibilities for implementing aspects include: memory devices, microcontrollers with memory (such as EEPROM), embedded microprocessors, firmware, software, etc. Furthermore, aspects may be embodied in microprocessors having software-based circuit emulation, discrete logic (sequential and combinatorial), custom devices, fuzzy (neural) logic, quantum devices, and hybrids of any of the above device types. The underlying device technologies may be provided in a variety of component types, e.g., metal-oxide semiconductor field-effect transistor ("MOSFET") technologies like complementary metal-oxide semiconductor ("CMOS"), bipolar technologies like emitter-coupled logic ("ECL"), polymer technologies (e.g., silicon-conjugated polymer and metal-conjugated polymer-metal structures), mixed analog and digital, and so on.

It should also be noted that the various logic and/or functions disclosed herein may be enabled using any number of combinations of hardware, firmware, and/or as data and/or instructions embodied in various machine-readable or computer-readable media, in terms of their behavioral, register transfer, logic component, and/or other characteristics. Computer-readable media in which such formatted data and/or instructions may be embodied include, but are not limited to, non-volatile storage media in various forms (e.g., optical, magnetic or semiconductor storage media) though again does not include transitory media. Unless the context clearly requires otherwise, throughout the description, the words "comprise," "comprising," and the like are to be construed in an inclusive sense as opposed to an exclusive or exhaustive sense; that is to say, in a sense of "including, but not limited to." Words using the singular or plural number also include the plural or singular number respectively. Additionally, the words "herein," "hereunder," "above," "below," and words of similar import refer to this application as a whole and not to any particular portions of this application. When the word "or" is used in reference to a list of two or more items, that word covers all of the following interpretations of the word: any of the items in the list, all of the items in the list and any combination of the items in the list.

Although certain presently preferred implementations of the invention have been specifically described herein, it will be apparent to those skilled in the art to which the invention pertains that variations and modifications of the various implementations shown and described herein may be made without departing from the scope of the invention. Accordingly, it is intended that the invention be limited only by the appended claims.

## Claims

1. A memory computation cell (40), consisting of:
an SRAM storage cell consisting of two cross-coupled inverters (M49 and M47, M410 and M48) forming a data port, D, and a complementary data port, Db, a read port consisting of (i) a first access transistor (M41) comprising a first terminal coupled to a read bit line, RBL, a gate coupled to a read enable line, RE, and a second terminal, and (ii) a second access transistor (M42) comprising a first terminal coupled to the second terminal of the first access transistor, a gate coupled to the complementary data port, and a second terminal coupled to ground;
a ratioless write port coupled to the SRAM storage cell that provides write access to the SRAM storage cell, the ratioless write port consisting of (i) a third access transistor (M412) comprising a first terminal coupled to a supply voltage, VDD, a gate coupled to a write bit line, WBL, and a second terminal coupled to the SRAM storage cell, (ii) a fourth access transistor (M411) comprising a first terminal coupled to the supply voltage, a gate coupled to a complementary write bit line, WBLb, and a second terminal coupled to the SRAM storage cell, (iii) a fifth access transistor (M45) comprising a first terminal coupled to the data port, a gate coupled to a write enable line, WE, and a second terminal, (iv) a sixth access transistor (M43) comprising a first terminal coupled to the second terminal of the fifth access transistor, a gate coupled to the complementary write bit line, and a second terminal coupled to ground, (v) a seventh access transistor (M46) comprising a first terminal coupled to the complementary data port, a gate coupled to the write enable line, and a second terminal, and (vi) an eighth access transistor (M44) comprising a first terminal coupled to the second terminal of the seventh access transistor, a gate coupled to the write bit line, and a second terminal coupled to ground, the ratioless write port permitting data to be written into the SRAM storage cell by disconnecting the third access transistor (M412) from the supply voltage.

2. A memory computation cell (50), consisting of:
an SRAM storage cell consisting of two cross-coupled inverters (M59 and M57, M510 and M58) forming a data port, D, and a complementary data port, Db;
a read port consisting of (i) a first access transistor (M51) comprising a first terminal coupled to a read bit line, RBL, a gate coupled to a read enable line, RE, and a second terminal, (ii) a second access transistor (M52) comprising a first terminal coupled to the second terminal of the first access transistor, a gate coupled to the complementary data port, and a second terminal coupled to ground, (iii) a third access transistor (M513) comprising a first terminal coupled to a complementary read bit line, RBLb, a gate coupled to a complementary read enable line, REb, and a second terminal, and (ii) a fourth access transistor (M514) comprising a first terminal coupled to the second terminal of the third access transistor, a gate coupled to the data port, and a second terminal coupled to ground;
a ratioless write port coupled to the SRAM storage cell that provides write access to the SRAM storage cell, the ratioless write port consisting of (i) a fifth access transistor (M512) comprising a first terminal coupled to a supply voltage, VDD, a gate coupled to a write bit line, WBL, and a second terminal coupled to the SRAM storage cell, (ii) a sixth access transistor (M511) comprising a first terminal coupled to the supply voltage, a gate coupled to a complementary write bit line, WBLb, and a second terminal coupled to the SRAM storage cell, (iii) a seventh access transistor (M55) comprising a first terminal coupled to the data port, a gate coupled to a write enable line, WE, and a second terminal, (iv) an eighth access transistor (M53) comprising a first terminal coupled to the second terminal of the seventh access transistor, a gate coupled to the complementary write bit line, and a second terminal coupled to ground, (v) a ninth access transistor (M56) comprising a first terminal coupled to the complementary data port, a gate coupled to the write enable line, and a second terminal, and (vi) a tenth access transistor (M54) comprising a first terminal coupled to the second terminal of the ninth access transistor, a gate coupled to the write bit line, and a second terminal coupled to ground, the ratioless write port permitting data to be written into the SRAM storage cell by disconnecting the fifth access transistor (M512) from the supply voltage.

3. A processing array (60), comprising:
a plurality of memory computation cells (Cell 00,..., Cell mn) according to either claim 1 or claim 2 arranged in an array, wherein the read port buffers the SRAM storage cell from signals on at least one read bit line and wherein the read bit line is configured to provide read access to a piece of data stored in the SRAM storage cell;
a word line generator (24, 62) that is coupled to a read word line signal and a write word line signal for each memory cell in the array;
a plurality of bit line read and write logic circuits (26, 64) that are coupled to the read bit line, write bit line and the complementary write bit line of each memory cell;
each memory cell being coupled to a write word line and a read word line whose signals are generated by the word line generator (24, 62) and also being coupled to the read bit line, the write bit line and the complementary write bit line that are sensed by one of the plurality of bit line read and write logic circuits (26, 64); and
wherein two or more of the memory cells are coupled to at least one read bit line and activated to perform one of a Boolean operations.

4. The processing array of claim 3, wherein the two cross-coupled inverter of the SRAM storage cell in each memory cell further comprises a first inverter having an input and an output and a second inverter having an input coupled to the output of the first inverter and an output coupled to the input of the first inverter, the first inverter including at least one storage PMOS transistor that is coupled to a first transfer PMOS transistor and the second inverter including a second storage PMOS transistor that is coupled to a second transfer PMOS transistor.

5. The processing array of claim 3 or 4, wherein the read port further comprises an isolation circuit that buffers the SRAM storage cell from signals on the at least one read bit line.

6. The processing array of claim 4, wherein the at least one storage PMOS transistor is a same size as each of the transfer PMOS transistors.

7. The processing array of one of claims 2 to 5 that is capable of performing a selective write operation.

8. The processing array of one of claims 4 to 6, wherein the transfer PMOS transistor turns off to cut off the storage PMOS transistor.

## Patentansprüche

1. Speicherberechnungszelle (40), bestehend aus:
einer SRAM-Speicherzelle, bestehend aus zwei kreuzgekoppelten Invertern (M49 und M47, M410 und M48), die einen Datenport, D, und einen komplementären Datenport, Db, bilden, einem Leseport, bestehend aus (i) einem ersten Zugriffstransistor (M41), der einen ersten Anschluss umfasst, der mit einer Lesebitleitung, RBL, gekoppelt ist, ein Gate, das mit einer Lesefreigabeleitung, RE, gekoppelt ist, und einen zweiten Anschluss, und (ii) einem zweiten Zugriffstransistor (M42), der einen ersten Anschluss umfasst, der mit dem zweiten Anschluss des ersten Zugriffstransistors gekoppelt ist, ein Gate, das mit dem komplementären Datenport gekoppelt ist, und einen zweiten Anschluss, der mit Masse gekoppelt ist;
einem ratiolosen Schreibport, der mit der SRAM-Speicherzelle gekoppelt ist und Schreibzugriff auf die SRAM-Speicherzelle bereitstellt, wobei der ratiolose Schreibport besteht aus (i) einem dritten Zugriffstransistor (M412), der einen ersten Anschluss umfasst, der mit einer Versorgungsspannung, VDD, gekoppelt ist, ein Gate, das mit einer Schreibbitleitung, WBL, gekoppelt ist, und einen zweiten Anschluss, der mit der SRAM-Speicherzelle gekoppelt ist, (ii) einem vierten Zugriffstransistor (M411), der einen ersten Anschluss umfasst, der mit der Versorgungsspannung gekoppelt ist, ein Gate, das mit einer komplementären Schreibbitleitung, WBLb, gekoppelt ist, und einen zweiten Anschluss, der mit der SRAM-Speicherzelle gekoppelt ist, (iii) einem fünften Zugriffstransistor (M45), der einen ersten Anschluss umfasst, der mit dem Datenport gekoppelt ist, ein Gate, das mit einer Schreibfreigabeleitung, WE, gekoppelt ist, und einen zweiten Anschluss, (iv) einem sechsten Zugriffstransistor (M43), der einen ersten Anschluss umfasst, der mit dem zweiten Anschluss des fünften Zugriffstransistors gekoppelt ist, ein Gate, das mit der komplementären Schreibbitleitung gekoppelt ist, und einen zweiten Anschluss, der mit Masse gekoppelt ist, (v) einem siebten Zugriffstransistor (M46), der einen ersten Anschluss umfasst, der mit dem komplementären Datenport gekoppelt ist, ein Gate, das mit der Schreibfreigabeleitung gekoppelt ist, und einen zweiten Anschluss, und (vi) einem achten Zugriffstransistor (M44), der einen ersten Anschluss umfasst, der mit dem zweiten Anschluss des siebten Zugriffstransistors gekoppelt ist, ein Gate, das mit der Schreibbitleitung gekoppelt ist, und einen zweiten Anschluss, der mit Masse gekoppelt ist, wobei der ratiolose Schreibport das Schreiben von Daten in die SRAM-Speicherzelle ermöglicht, indem der dritte Zugriffstransistor (M412) von der Versorgungsspannung getrennt wird.

2. Speicherberechnungszelle (50), bestehend aus:
einer SRAM-Speicherzelle, bestehend aus zwei kreuzgekoppelten Invertern (M59 und M57, M510 und M58), die einen Datenport, D, und einen komplementären Datenport, Db, bilden;
einem Leseport, bestehend aus (i) einem ersten Zugriffstransistor (M51), der einen ersten Anschluss umfasst, der mit einer Lesebitleitung, RBL, gekoppelt ist, ein Gate, das mit einer Lesefreigabeleitung, RE, gekoppelt ist, und einen zweiten Anschluss, (ii) einem zweiten Zugriffstransistor (M52), der einen ersten Anschluss umfasst, der mit dem zweiten Anschluss des ersten Zugriffstransistors gekoppelt ist, ein Gate, das mit dem komplementären Datenport gekoppelt ist, und einen zweiten Anschluss, der mit Masse gekoppelt ist, (iii) einem dritten Zugriffstransistor (M513), der einen ersten Anschluss umfasst, der mit einer komplementären Lesebitleitung, RBLb, gekoppelt ist, ein Gate, das mit einer komplementären Lesefreigabeleitung, Reb, gekoppelt ist, und einen zweiten Anschluss, und (ii) einem vierten Zugriffstransistor (M514), der einen ersten Anschluss umfasst, der mit dem zweiten Anschluss des dritten Zugriffstransistors gekoppelt ist, ein Gate, das mit dem Datenport gekoppelt ist, und einen zweiten Anschluss, der mit Masse gekoppelt ist;
einem ratiolosen Schreibport, der mit der SRAM-Speicherzelle gekoppelt ist und Schreibzugriff auf die SRAM-Speicherzelle bereitstellt, wobei der ratiolose Schreibport besteht aus (i) einem fünften Zugriffstransistor (M512), der einen ersten Anschluss umfasst, der mit einer Versorgungsspannung, VDD, gekoppelt ist, ein Gate, das mit einer Schreibbitleitung, WBL, gekoppelt ist, und einen zweiten Anschluss, der mit der SRAM-Speicherzelle gekoppelt ist, (ii) einem sechsten Zugriffstransistor (M511), der einen ersten Anschluss umfasst, der mit der Versorgungsspannung gekoppelt ist, ein Gate, das mit einer komplementären Schreibbitleitung, WBLb, gekoppelt ist, und einen zweiten Anschluss, der mit der SRAM-Speicherzelle gekoppelt ist, (iii) einem siebten Zugriffstransistor (M55), der einen ersten Anschluss umfasst, der mit dem Datenport gekoppelt ist, ein Gate, das mit einer Schreibfreigabeleitung, WE, gekoppelt ist, und einen zweiten Anschluss, (iv) einem achten Zugriffstransistor (M53), der einen ersten Anschluss umfasst, der mit dem zweiten Anschluss des siebten Zugriffstransistors gekoppelt ist, ein Gate, das mit der komplementären Schreibbitleitung gekoppelt ist, und einen zweiten Anschluss, der mit Masse gekoppelt ist, (v) einem neunten Zugriffstransistor (M56), der einen ersten Anschluss umfasst, der mit dem komplementären Datenport gekoppelt ist, ein Gate, das mit der Schreibfreigabeleitung gekoppelt ist, und einen zweiten Anschluss, und (vi) einem zehnten Zugriffstransistor (M54), der einen ersten Anschluss umfasst, der mit dem zweiten Anschluss des neunten Zugriffstransistors gekoppelt ist, ein Gate, das mit der Schreibbitleitung gekoppelt ist, und einen zweiten Anschluss, der mit Masse gekoppelt ist, wobei der ratiolose Schreibport das Schreiben von Daten in die SRAM-Speicherzelle ermöglicht, indem der fünfte Zugriffstransistor (M512) von der Versorgungsspannung getrennt wird.

3. Verarbeitungsarray (60), umfassend:
eine Mehrzahl von Speicherberechnungszellen (Cell 00, ... , Cell mn) gemäß entweder Anspruch 1 oder Anspruch 2, die in einem Array angeordnet sind, wobei der Leseport die SRAM-Speicherzelle gegenüber Signalen auf mindestens einer Lesebitleitung puffert und wobei die Lesebitleitung dazu konfiguriert ist, Lesezugriff auf ein in der SRAM-Speicherzelle gespeichertes Datenelement bereitzustellen;
einen Wortleitungsgenerator (24, 62), der mit einem Lesewortleitungssignal und einem Schreibwortleitungssignal für jede Speicherzelle im Array gekoppelt ist;
eine Mehrzahl von Bitleitungs-Lese- und -Schreiblogikschaltungen (26, 64), die mit der Lesebitleitung, der Schreibbitleitung und der komplementären Schreibbitleitung jeder Speicherzelle gekoppelt sind;
wobei jede Speicherzelle mit einer Schreibwortleitung und einer Lesewortleitung gekoppelt ist, deren Signale vom Wortleitungsgenerator (24, 62) erzeugt werden, und außerdem mit der Lesebitleitung, der Schreibbitleitung und der komplementären Schreibbitleitung gekoppelt ist, die von einer der Mehrzahl der Bitleitungs-Lese- und -Schreiblogikschaltungen (26, 64) erfasst werden; und
wobei zwei oder mehr der Speicherzellen mit mindestens einer Lesebitleitung gekoppelt und aktiviert sind, um eine der Booleschen Operationen durchzuführen.

4. Verarbeitungsarray nach Anspruch 3, wobei die zwei kreuzgekoppelten Inverter der SRAM-Speicherzelle in jeder Speicherzelle ferner einen ersten Inverter mit einem Eingang und einem Ausgang und einen zweiten Inverter mit einem Eingang, der mit dem Ausgang des ersten Inverters gekoppelt ist, und einem Ausgang, der mit dem Eingang des ersten Inverters gekoppelt ist, umfassen, wobei der erste Inverter mindestens einen Speicher-PMOS-Transistor enthält, der mit einem ersten Transfer-PMOS-Transistor gekoppelt ist, und der zweite Inverter einen zweiten Speicher-PMOS-Transistor enthält, der mit einem zweiten Transfer-PMOS-Transistor gekoppelt ist.

5. Verarbeitungsarray nach Anspruch 3 oder 4, wobei der Leseport ferner eine Isolationsschaltung umfasst, die die SRAM-Speicherzelle gegenüber Signalen auf der mindestens einen Lesebitleitung puffert.

6. Verarbeitungsarray nach Anspruch 4, wobei der mindestens eine Speicher-PMOS-Transistor eine gleiche Größe wie jeder der Transfer-PMOS-Transistoren aufweist.

7. Verarbeitungsarray nach einem der Ansprüche 2 bis 5, das in der Lage ist, einen selektiven Schreibvorgang durchzuführen.

8. Verarbeitungsarray nach einem der Ansprüche 4 bis 6, wobei der Transfer-PMOS-Transistor abschaltet, um den Speicher-PMOS-Transistor abzuschalten.

## Revendications

1. Une cellule de mémoire de calcul (40), comprenant :
une cellule de mémoire SRAM comprenant deux inverseurs reliés en croix (M49 et M47, M410 et M48) formant un port de données, D, et un port de données complémentaire, Db, un port de lecture comprenant (i) un premier transistor d'accès (M41) comprenant une première borne reliée à une ligne de bits de lecture, RBL, une grille reliée à une ligne de validation de lecture, RE, une deuxième borne, et (ii) un deuxième transistor d'accès (M42) comprenant une première borne reliée à la deuxième borne du premier transistor d'accès, une grille reliée au port de données complémentaire, et une deuxième borne reliée à la terre ;
un port d'écriture sans ratio relié à la cellule de mémoire SRAM qui fournit un accès à l'écriture à la cellule de mémoire SRAM, le port d'écriture sans ratio comprenant (i) un troisième transistor d'accès (M412) comprenant une première borne reliée à une tension d'alimentation, VDD, une grille reliée à une ligne de bits d'écriture, WBL, et une deuxième borne reliée à la cellule de mémoire SRAM, (ii) un quatrième transistor d'accès (M411) comprenant une première borne reliée à la tension d'alimentation, une grille reliée à une ligne de bits d'écriture complémentaire, WBLb, et une deuxième borne reliée à la cellule de mémoire SRAM, (iii) un cinquième transistor d'accès (M45) comprenant une première borne reliée au port de données, une grille reliée à une ligne de validation d'écriture, WE, et une deuxième borne, (iv) un sixième transistor d'accès (M43) comprenant une première borne reliée à la deuxième borne du cinquième transistor d'accès, une grille reliée à la ligne de bits d'écriture complémentaire, et une deuxième borne reliée à la terre, (v) un septième transistor d'accès (M46) comprenant une première borne reliée au port de données complémentaire, une grille reliée à la ligne de validation d'écriture, et une deuxième borne, et (vi) un huitième transistor d'accès (M44) comprenant une première borne reliée à la deuxième borne du septième transistor d'accès, une grille reliée à la ligne de bits d'écriture, et une deuxième borne reliée à la terre, le port d'écriture sans ratio permettant d'écrire des données dans la cellule de mémoire SRAM en déconnectant le troisième transistor d'accès (M412) de la tension d'alimentation.

2. Une cellule de calcul de mémoire (50), comprenant :
une cellule de mémoire SRAM comprenant deux inverseurs reliés en croix (M59 et M57, M510 et M58) formant un port de données, D, et un port de données complémentaire, Db ;
un port de lecture comprenant (i) un premier transistor d'accès (M51) comprenant une première borne reliée à une ligne de bits de lecture, RBL, une grille reliée à une ligne de validation de lecture, RE, et une deuxième borne, (ii) un deuxième transistor d'accès (M52) comprenant une première borne reliée à la deuxième borne du premier transistor d'accès, une grille reliée au port de données complémentaire, et une deuxième borne reliée à la terre, (iii) un troisième transistor d'accès (M513) comprenant une première borne reliée à une ligne de bits de lecture complémentaire, RBLb, une grille reliée à une ligne de validation de lecture complémentaire, REb, et une deuxième borne, et (ii) un quatrième transistor d'accès (M514) comprenant une première borne reliée à la deuxième borne du troisième transistor d'accès, une grille reliée au port de données, et une deuxième borne reliée à la terre ;
`un port d'écriture sans ratio relié à la cellule de mémoire SRAM qui fournit un accès en écriture à la cellule de mémoire SRAM, le port d'écriture sans ratio comprenant (i) un cinquième transistor d'accès (M512) comprenant une première borne reliée à une tension d'alimentation, VDD, une grille reliée à une ligne de bits d'écriture, WBL, et une deuxième borne reliée à la cellule de mémoire SRAM, (ii) un sixième transistor d'accès (M511) comprenant une première borne reliée à la tension d'alimentation, une grille reliée à une ligne de bits d'écriture complémentaire, WBLb, et une deuxième borne reliée à la cellule de mémoire SRAM, (iii) un septième transistor d'accès (M55) comprenant une première borne reliée au port de données, une grille reliée à une ligne de validation d'écriture, WE, et une deuxième borne, (iv) un huitième transistor d'accès (M53) comprenant une première borne reliée à la deuxième borne du septième transistor d'accès, une grille reliée à la ligne de bits d'écriture complémentaire, et une deuxième borne reliée à la terre, (v) un neuvième transistor d'accès (M56) comprenant une première borne reliée au port de données complémentaire, une grille reliée à la ligne de validation d'écriture, et une deuxième borne, et (vi) un dixième transistor d'accès (M54) comprenant une première borne reliée à la deuxième borne du neuvième transistor d'accès, une grille reliée à la ligne de bits d'écriture, et une deuxième borne reliée à la terre, le port d'écriture sans ratio permettant d'écrire des données dans la cellule de mémoire SRAM en déconnectant le cinquième transistor d'accès (M512) de la tension d'alimentation.

3. Un dispositif de réseau de traitement (60), comprenant :
une pluralité de cellules de calcul de mémoire (Cell 00, ..., Cell mn) selon soit la revendication 1, soit la revendication 2, agencées en une matrice, le port de lecture mettant en tampon la cellule de mémoire SRAM à partir de signaux sur au moins une ligne de bits de lecture et la ligne de bits de lecture étant configurée pour fournir un accès en lecture à une donnée stockée dans la cellule de mémoire SRAM ;
un générateur de lignes de mots (24, 62) qui est relié à un signal de ligne de mots de lecture et à un signal de ligne de mots d'écriture pour chaque cellule de mémoire dans le réseau ;
une pluralité de circuits logiques (26, 64) de lecture et d'écriture de lignes de bits qui sont reliés à la ligne de bits de lecture, à la ligne de bits d'écriture et à la ligne de bits d'écriture complémentaire de chaque cellule de mémoire :
chaque cellule de mémoire étant reliée à une ligne de mots d'écriture et à une ligne de mots de lecture dont les signaux sont générés par le générateur de lignes de mots (24, 62) et étant également reliée à la ligne de bits de lecture, à la ligne de bits d'écriture et à la ligne de bits d'écriture complémentaire qui sont détectées par un circuit logique de la pluralité des circuits logiques (26, 64) de lecture et d'écriture de lignes de bits ; et
deux ou plusieurs des cellules de mémoire sont reliées à au moins une ligne de bits de lecture et activées pour effectuer l'une des opérations booléennes.

4. Le dispositif de réseau de traitement selon la revendication 3, dans lequel les deux inverseurs reliés en croix de la cellule de stockage SRAM dans chaque cellule de mémoire comprennent en outre un premier inverseur ayant une entrée et une sortie et un deuxième inverseur ayant une entrée reliée à la sortie du premier inverseur et une sortie reliée à l'entrée du premier inverseur, le premier inverseur comprenant au moins un transistor PMOS de stockage qui est relié à un premier transistor PMOS de transfert, et le deuxième inverseur comprenant un deuxième transistor PMOS de stockage qui est relié à un deuxième transistor PMOS de transfert.

5. Le dispositif de réseau de traitement selon la revendication 3 ou la revendication 4, dans lequel le port de lecture comprend en outre un circuit d'isolation qui met en tampon la cellule de mémoire SRAM par rapport aux signaux sur ladite au moins une ligne de bits de lecture.

6. Le dispositif de réseau de traitement selon la revendication 4, dans lequel ledit au moins un transistor PMOS de stockage est de même taille que chacun des transistors PMOS de transfert.

7. Le dispositif de réseau de traitement selon l'une des revendications 2 à 5, qui est apte à effectuer une opération d'écriture sélective.

8. Le dispositif de réseau de traitement selon l'une des revendications 4 à 6, dans lequel le transistor PMOS de transfert se désactive pour couper le transistor PMOS de stockage.
